# EUROPÄISCHE PATENTSCHRIFT

(11) **EP 1 406 831 B1**
(45) Veröffentlichungstag und Bekanntmachung des Hinweises auf die Patenterteilung: **21.06.2006**
(21) Anmeldenummer: 02754309.9
(22) Anmeldetag: 04.07.2002
(51) Int. Cl.: B81B 7/00, B81C 1/00

(54) **Mikromechanische Kappenstruktur und entsprechendes Herstellungsverfahren**
Micromechanical cap structure and a corresponding production method
Structure de capuchon microméchanique et procédé de fabrication correspondant

(30) Priorität: 05.07.2001 DE 10132683
(43) Veröffentlichungstag der Anmeldung: 14.04.2004
(73) Patentinhaber: ROBERT BOSCH GMBH, 70442 Stuttgart (DE)
(72) Erfinder: FISCHER, Frank, 72810 Gomaringen (DE); HEIN, Peter, 72770 Reutlingen (DE); GRAF, Eckhard, 72810 Gomaringen (DE)
(86) Internationale Anmeldenummer: PCT/DE2002/002430
(87) Internationale Veröffentlichungsnummer: WO 2003/004403

(56) Entgegenhaltungen:
- WO-A-85/05737
- DE-A- 4 027 753
- US-A- 4 498 070
- PATENT ABSTRACTS OF JAPAN vol. 011, no. 073 (E-486), 5. März 1987 (1987-03-05) -& JP 61 230382 A (YOKOGAWA ELECTRIC CORP), 14. Oktober 1986 (1986-10-14)

## Beschreibung

### STAND DER TECHNIK

Die vorliegende Erfindung betrifft eine mikromechanische Kappenstruktur und ein entsprechendes Herstellungsverfahren.

Obwohl prinzipiell auf beliebige mikromechanische Bauelemente anwendbar, werden die vorliegende Erfindung sowie die ihr zugrundeliegende Problematik in bezug auf diesen bekannten oberflächenmikromechanischen Beschleunigungssensor näher erläutert.

In der DE 195 37 814 werden der Aufbau eines Schichtsystems sowie ein Verfahren der hermetischen Verkappung von Sensoren, insbesondere Drehraten- oder Beschleunigungssensoren, in Oberflächenmikromechanik beschrieben. Hierbei wird die Herstellung der Sensorstruktur mit bekannten technologischen Verfahren erläutert. Die Verkappung erfolgt mit einem separaten Kappenwafer aus Silizium, der mit aufwendigen Strukturierungsprozessen, wie beispielsweise KOH-Ätzen, strukturiert wird. Der Kappenwafer wird auf Waferebene mit einem Glas-Lot (Seal-Glas) auf den Sensorwafer aufgebracht. Hierfür ist um jeden Sensor-Chip ein breiter Bond-Rahmen notwendig, um eine ausreichende Haftung und Dichtheit des Kappenwafers zu gewährleisten.

Man kann sich eine anodische Bondverbindung zwischen einem Kappenwafer und einem Sensorwafer vorstellen, wobei elektrische Kontakte an den Sensorwafer von der Rückseite eines Si-Substrates durch Isolationsgräben erzeugt werden.

Ein Problem bei solch einem anodischen Verkappungsverfahren besteht darin, dass der verwendete Glas-Si-Compositewafer (vornehmlich Pyrex-Glas) aufwendig herzustellen ist. Die Folge an Schleif- Polier- und Ätzprozessen erhöht die Prozesskosten. Die Prozeßsicherheit, insbesondere für die Dikkeneinstellung des Glaswafers, ist nur unter Vorgabe von weiten Toleranzgrenzen zu erreichen. Die Strukturierung der Kappenkaverne in Pyrex mit naßchemischen Ätzverfahren wie beispielsweise BOE (buffered oxide etch) ist teuer und stößt bei großen Ätztiefen von 5-10 µm auf Probleme bzgl. Lackhaftung und Oberflächenrauhigkeit.

Ein wesentlicher Nachteil der technischen Ausführung ergibt sich im Hinblick auf die anodische Bondverbindung mit gleichzeitiger Formierung eines Metall-Halbleiter-Kontaktes. Durch die Überlappung eines eingebrachten Metall-inlays, das beim anodischen Bonden den Kavernenraum feld-frei halten soll, mit dem Bondrahmen wird ein starrer Abstandshalter eingebracht, der die Bondverbindung stark stört und zu Undichtheit führen kann.

Aus der Literatur sind weiterhin Kraft oder Drucksensoren bekannt, die eine Grundschicht, eine Deckschicht und dazwischen angeordnete Stützstrukturen aufweisen. Die deutsche Offenlegungsschrift DE 40 27 753 A1 beschreibt einen Kraftsensor mit einem Grundkörper, Abstandshaltern und einen Deckkörper wobei infolge einer Krafteinwirkung der Kompressionsmodul zu einer Verformung wenigstens einer dieser Teile führt. Die Verformung führt zu einem verringerten Abstand der einander zugewandten Seiten von Grundkörper und Deckkörper, was kapazitiv gemessen wird. Zwischen Abstandshalter und Grundkörper bzw. Deckkörper ist eine Verbindungsschicht angeordnet, welche auch metallisch sein kann. Die Dicke des Grundkörpers 1 und des Deckkörpers 8 ist jeweils so gewählt, dass eine Verformung durch Stauchung und Kompression und nicht durch eine Durchbiegung des Körpers erfolgt. Die Patenschrift US 4498070 zeigt einen Drucksensor mit einem Substrat mit einer Ausnehmung und darauf angeordnet eine Halbleiterschicht mit einem Stempel. Eine Auslenkung der Halbleiterschicht infolge von Druck wird induktiv gemessen. Zur Begrenzung der Auslenkung der Halbleiterschicht weist das Substrat Strukturen auf, die von Ausnehmungen in der Halbleiterschicht umfasst werden.

### VORTEILE DER ERFINDUNG

Die erfindungsgemäße mikromechanische Kappenstruktur mit den Merkmalen des Anspruchs 1 und das entsprechende Herstellungsverfahren nach Anspruch 7 weisen gegenüber dem bekannten Lösungsansatz den Vorteil auf, daß ein Verfahren und eine Vorrichtung bereitgestellt werden, wodurch die Kappe kostengünstiger hergestellt und der Bondprozeß fertigungssicher durchgeführt werden kann. Hierfür wird der Metall-Halbleiter-Kontakt außerhalb des Bondrahmens in den Stützbereich plaziert und federnd ausgelegt, um eine dauerhafte und stabile elektrische Anbindung zu gewährleisten.

In den Unteransprüchen finden sich vorteilhafte Weiterbildungen und Verbesserungen des betreffenden Gegenstandes der Erfindung.

Gemäß einer bevorzugten Weiterbildung weist die Stützstruktur einen zentralen Stützbereich auf dem zweiten Wafer und einen entsprechenden zentralen Gegenstützbereich auf dem ersten Wafer auf.

Gemäß einer weiteren bevorzugten Weiterbildung weist die Verbindungsstruktur einen umlaufenden Randbereich des ersten Wafers und einen damit anodisch verbundenen umlaufenden Randbereich des zweiten Wafers auf.

Gemäß einer weiteren bevorzugten Weiterbildung weist der zweite Wafer eine um den Stützbereich verlaufende ringförmige Kaverne auf.

Gemäß einer weiteren bevorzugten Weiterbildung weist der zweite Wafer eine metallische Inlay-Struktur auf, welche den Stützbereich und die Kaverne zumindest teilweise auskleidet und den Randbereich ausspart. Mit dem beschriebenen Verfahren läßt sich ebenfalls ein feldfreier Raum in der Kaverne erzeugen. Ein weiterer Vorteil ergibt sich im Hinblick auf das Design der Metallschicht, wodurch vermieden wird, dass die Metallschicht im Bereich des Bondrahmens den Bondvorgang stört. Vielmehr wird das Metallinlay erfindungsgemäß derart strukturiert, dass der Metallkontakt beim Bondvorgang federnd ausgebildet wird. Hierzu wird der Metall-Silizium-Kontakt im Zentrum der Kappenmembran angebracht. In diesem Bereich kann die Membran elastisch verspannt werden. Damit wird einerseits die Unebenheit, die durch das Metall eingebracht wird ausgeglichen und andererseits eine federnde, reproduzierbare Verbindung zwischen Metall und Silizium erzielt.

Gemäß einer weiteren bevorzugten Weiterbildung ist die Kaverne in dem Grundmaterial des zweiten Wafers vorgesehen ist, wobei eine Glaschicht auf der Kaverne, dem Randbereich und dem Stützbereich vorgesehen ist. Zweckmäßigerweise wird die Kappenkaverne mit einer Tiefe von 5-10 µm nicht in ein Oxid sondern im Siliziumsubstrat des Kappenwafers zu strukturiert. Hierdurch wird der Vorteil ausgenützt, dass bekannte Si-Tiefenstrukturierungsverfahren, wie beispielsweise RIE (reactive ion etching), nicht durch Limitierungen begrenzt sind, wie die naßchemische Tiefenstrukturierung von Pyrex mit BOE.

Als wesentliche Verbesserung wird vorgeschlagen, dass der Kappen-Composite-Wafer nicht aus einem auf Silizium gebondeten Pyrex-Wafer gebildet wird. Zweckmäßigerweise wird auf dem in Silizium strukturierten Kappensubstrat eine dünne Glasschicht aufgesputtert, wie es beispielsweise in A. Drost et al., Anodic Bonding with Sputtered Pyrex Glass Layers, Proc. of the Micro Materials Conference Berlin, 1997, S. 933 beschrieben ist, oder mit einem Spin-On-Verfahren aufgebracht. Dadurch werden erheblich geringere Prozeßkosten und deutlich geringere Prozeßschwankungen erwartet, als bei der Composite-Herstellung durch Abdünnen eines massiven Pyrex-Wafers.

Darüberhinaus bietet der erfindungsgemäße Dünnschichtprozeß den Vorteil, in den Verkappungsprozeß eines vollintegrierten OMM-Sensors übertragen werden zu können. Der Dünnschicht-Bondprozeß mit gesputtertem oder aufgedampften oder aufgeschleuderten Pyrexgläsern oder Pyrex-ähnlichen Gläsern wird als Schlüsselprozeß zur Verkappung von integrierten Sensoren betrachtet.

### ZEICHNUNGEN

Ausführungsbeispiele der Erfindung sind in den Zeichnungen dargestellt und in der nachfolgenden Beschreibung näher erläutert.

Es zeigen:
- Fig. 1a-e: die Herstellungssequenz des Kappenwafers gemäß einer Ausführungsform des erfindungsgemäßen Herstellungsverfahrens; und
- Fig. 2a,b: die Herstellungssequenz einer Ausführungsform der erfindungsgemäßen Kappenstruktur gemäß der Ausführungs form des erfindungsgemäßen Herstellungsverfahrens.

### BESCHREIBUNG DER AUSFÜHRUNGSBEISPIELE

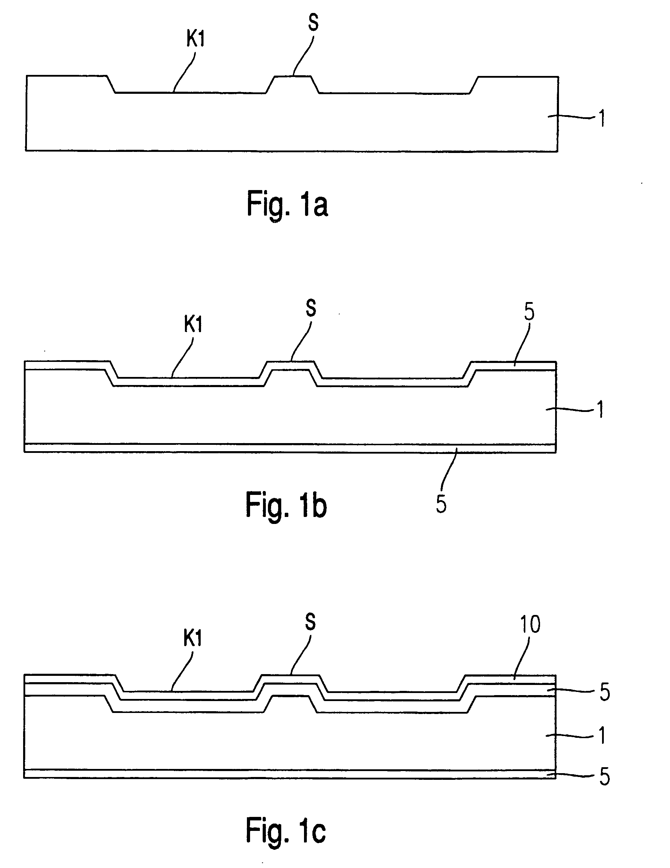

In Fig. 1a-e ist die Herstellungssequenz des Kappenwafers gemäß einer Ausführungsform des erfindungsgemäßen Herstellungsverfahrens dargestellt.

Ein Silizium-Kappenwafer 1 wird gemäß Fig. 1a mit einem bekannten Trockenätzverfahren derart strukturiert, daß er z.B. eine ringförmige Kaverne K1 mit einer Ätztiefe von ca. 5 bis 10 Mikrometern aufweist. Die Dicke des Kappenwafers 1 liegt bei ca. 200-700 um. Bevorzugt werden ca. 320 µm wegen der Federwirkung der Kappenmembran beim anodischem Bonden.

Die Struktur des Kappenwafers 1 beinhaltet einen Stützbereich S, der für eine stabilisierende Stützstelle vorgesehen ist.

Durch thermische Oxidation oder ein CVD-Verfahren wird gemäß Fig. 1b eine dünne 0,5-2µm dicke Oxidschicht 5 aufgebracht, die beim anodischen Bonden die Durchbruchfestigkeit der Bondschicht gewährleisten soll.

Auf der Oxidschicht 5 wird gemäß Fig. 1c eine Glasschicht 10 mit einem reaktiven, sauerstoffreichen Sputter- bzw. Aufdampfverfahren aufgebracht bzw. mit einem Spin-On-Verfahren aufgeschleudert. Diese Glasschicht 10 soll anodisch bondbar sein. Bevorzugt wird ein Glas, dessen Zusammensetzung ähnlich oder gleich der von Pyrex oder Borofloat ist. Dieser Verfahrensschritt ist aus dem Stand der Technik bekannt.

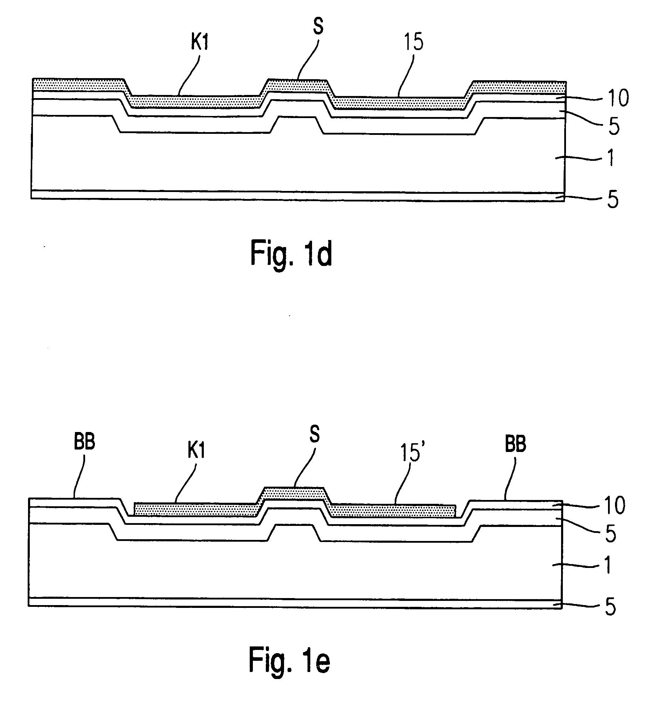

Auf der Struktur wird gemäß Fig. 1d eine Metallschicht 15 aufgebracht, z.B. aus Aluminium. Ein besonders positiver Effekt ergibt sich bei der Verwendung von Aluminium als Metall, denn dieses Material kann den beim späteren Bonden entstehenden Sauerstoff durch chemische Umwandlung absorbieren. Damit wird der Innendruck der Kaverne reduziert.

Gemäß Fig. 1e wird durch einen naß- oder trockenchemischen Verfahrensschritt wird eine Inlay-Struktur 15' aus der Metallschicht 15 erzeugt, die den gesamten Bereich der Kaverne auskleidet. Das Metall wird dabei nicht in den äußeren Verbindungsbereich BB gezogen bzw. davon entfernt. Die Kontaktstelle zwischen Metall und Silizium befindet sich auf der Stützstelle S im Zentrum der Kappenmembran. Die Schichtdicke d_{M} des Metalls beträgt zwischen 50nm und 1µm.

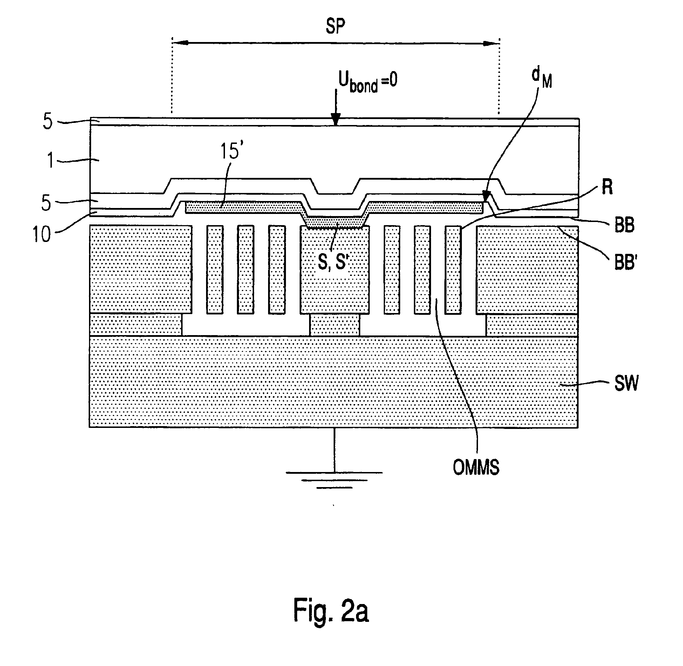

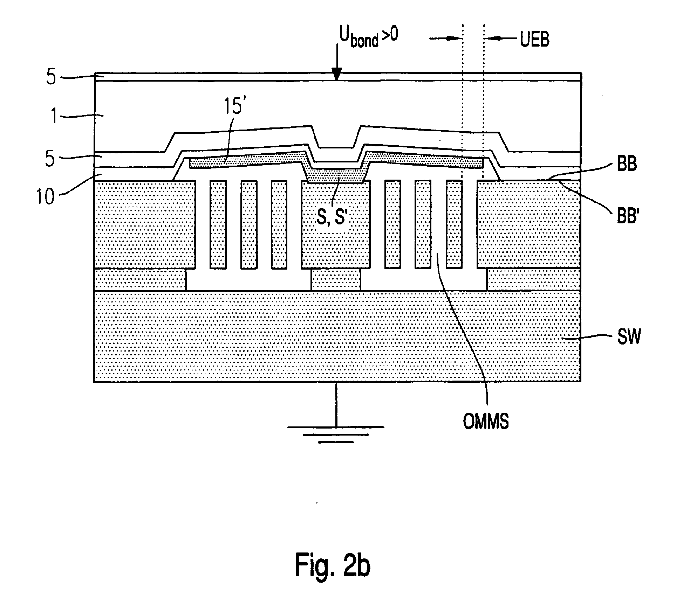

Fig. 2a,b zeigen die Herstellungssequenz einer Ausführungsform der erfindungsgemäßen Kappenstruktur gemäß der Ausführungsform des erfindungsgemäßen Herstellungsverfahrens.

Wie Fig. 2a zu entnehmen, verläuft das Metall der Inlay-Struktur 15' innerhalb der Kaverne und ist über den Rand R der in den vorstrukturierten Sensorwafer SW integrierten beweglichen OMM-Struktur OMMS, hier ein Beschleunigungssensor, hinausgezogen, um beim anodischen Bonden Streufelder ausreichend abzuschirmen. Die Spannweite SP der Inlay-Struktur 15' innerhalb der Kaverne beträgt typischerweise 700 - 2000 µm.

Beim Verbinden des Kappenwafers 1 und des vorstrukturierten Sensorwafers SW mit anodischen Bonden setzt der Mittelbereich des Kappenwafers 1 zunächst mit dem metallisierten Stützstempel S auf einem entsprechenden Gegenstützstempel S' des Sensorwafers SW auf. Solange die zwischen der Rückseite des Kappenwafers 1 und der Rückseite des Sensorwafers SW angelegte Bondspannung U_{Bond} gleich Null ist, liegt gemäß Fig. 2a der Randbereich BB der Vorderseite des Kappenwafers 1 nicht auf dem Bondbereich BB' aus Silizium auf der Vorderseite des Sensorwafers SW auf.

Beim Anlegen der elektrischen Bondspannung U_{Bond} hingegen wird gemäß Fig. 2b der Randbereich BB der Vorderseite des Kappenwafers 1 auf dem Bondbereich BB' auf der Vorderseite des Sensorwafers SW heruntergezogen.

Durch die Lage des Stützstempels S bzw. des Gegenstützstempels S' in der Mitte des Kappenwafers 1 bzw. des Sensorwafers SW kann sich der Kappenwafer 1 flexibel wölben. Damit können die Verbindungsflächen BB, BB' trotz der Metallstufe in der Mitte miteinander in direkten Kontakt gebracht werden. Darüber hinaus wird durch die federnde Verbindung zwischen Metall und Silizium ein ausreichender Kontakt geschaffen, der durch geeignete Materialwahl auch als Legierungskontakt ausgebildet werden kann.

Die Mittenabstützung S, S' erhöht die mechanische Stabilität des Sandwiches und schwächt temperaturabhängige Änderungen in der Kappen- bzw. Substratdurchbiegung ab. Der Metallfilm 15' in der Kaverne ist elektrisch mit dem Silizium des Bondrahmens und der beweglichen OMM-Struktur OMMS verbunden. Dadurch werden elektrische Felder beim Anlegen einer Bondspannung U_{bond}>0 zwischen der Bondelektrode und dem Sensorwafer SW abgeschirmt. Um Streufelder von der beweglichen Struktur OMMS fern zu halten, muß ein ausreichender Überlapp UEB von mindestens 5µm zwischen der Metallaußenkante und dem Rand R der beweglichen Struktur OMMS eingehalten werden.

In der weiteren Prozessierung werden Kontakte von der Rückseite des Sensorwafers angebracht, wie im Stand der Technik bekannt ist.

Obwohl die vorliegende Erfindung vorstehend anhand bevorzugter Ausführungsbeispiele beschrieben wurde, ist sie darauf nicht beschränkt, sondern auf vielfältige Weise modifizierbar.

Insbesondere ist mit dem erfindungsgemäßen Verfahren die Verkappung beliebiger mikromechanischer Funktionsstrukturen möglich.

Auch kann man sich vorstellen, daß mehrere Stütz- bzw. Gegenstützbereiche im Innenbereich des Kappen- und Sensorwafers vorgesehen sind.

## Patentansprüche

1. Mikromechanische Kappenstruktur mit:
- einem ersten Wafer (SW) mit einer mikromechanischen Funktionsstruktur (OMMS),
- einem zweiten Wafer (1) zum Bilden einer Kappe über der mikromechanischen Funktionsstruktur (OMMS),
- wobei der erste und zweite Wafer (SW, 1) in einem gemeinsamen Randbereich eine Verbindungsstruktur (BB, BB') aufweisen, welche die beiden Wafer (SW, 1) miteinander verbindet,
**dadurch gekennzeichnet, dass**
- der erste und zweite Wafer (SW, 1) in einem gemeinsamen Innenbereich eine Stützstruktur (S, S') mit einem Metall-Halbleiter-Kontakt zur elektrischen Anbindung von wenigstens Teilen des ersten und zweiten Wafers (SW, 1) aneinander aufweisen,
- wobei der Metall-Halbleiter-Kontakt federnd geschlossen ausgestaltet ist,
- und wobei der erste Wafer (SW) wenigstens im Bereich der Stützstruktur (S, S') aus einem Halbleitermaterial besteht.

2. Mikromechanische Kappenstruktur nach Anspruch 1, **dadurch gekennzeichnet, dass** der zweite Wafer (1) eine elastische Verspannung aufweist, derart dass der Metall-Halbleiter-Kontakt geschlossen ist.

3. Mikromechanische Kappenstruktur nach Anspruch 2, **dadurch gekennzeichnet, dass** der Randbereich des zweiten Wafers (1) im verkappten Zustand gegenüber dem Innenbereich des zweiten Wafers (1) gewölbt ist.

4. Mikromechanische Kappenstruktur nach einem der vorhergehenden Ansprüche, **dadurch gekennzeichnet, dass** die Stützstruktur (S, S') einen zentralen Stützbereich (5) auf dem zweiten Wafer (1) und einen entsprechenden zentralen Gegenstützbereich (S') auf dem ersten Wafer (SW) aufweist.

5. Mikromechanische Kappenstruktur nach einem der vorhergehenden Ansprüche, **dadurch gekennzeichnet, dass** die Verbindungsstruktur (BB, BB') einen umlaufenden Randbereich (33') des ersten Wafers (SW) und einen damit anodisch verbundenen umlaufenden Randbereich (BB) des zweiten Wafers (1) aufweist.

6. Mikromechanische Kappenstruktur nach einem der vorhergehenden Ansprüche, **dadurch gekennzeichnet; dass** der zweite Wafer (1) eine um den Stützbereich (S) verlaufende ringförmige Kaverne (K1) aufweist.

7. Mikromechanische Kappenstruktur nach Anspruch 6, **dadurch gekennzeichnet, dass** der zweite Wafer (1) eine metallische Inlay-Struktur (15') aufweist, welche den Stützbereich (S) und die Kaverne (K1) zumindest teilweise auskleidet und den Randbereich (BB) ausspart, wobei die metallische Inlay-Struktur (15') mit dem Metall-Halbleiter-Kontakt in elektrischer Verbindung steht.

8. Mikromechanische Kappenstruktur nach einem der vorhergehenden Ansprüche 6 oder 7, **dadurch gekennzeichnet, dass** die Kaverne (K1) in dem Grundmaterial des zweiten Wafers (1) vorgesehen ist und eine Glasschicht (5) auf der Kaverne (K1), dem Randbereich (BB) und dem Stützbereich (S) vorgesehen ist.

9. Verfahren zur Verfahren zu Herstellen einer mikromechanischen Kappenstruktur nach mindestens einem der vorhergehenden Ansprüche, **gekennzeichnet durch** die Schritte:
- Aufeinanderlegen des ersten und zweiten Wafers (1, SW) derart, dass die Teile der Stützstruktur (S, S') eine gemeinsame Berührungsfläche bilden und die Teile der späteren Verbindungsstruktur (BB, BB') einander gegenüberliegend ausgerichtet sind,
- Anlegen einer anodischen Bondspannung (UBOND) zwischen dem ersten und dem zweiten Wafer (1, SW), so dass der Randbereich (BB) der Vorderseite des zweiten Wafers (1) auf den Randbereich (BB') auf der Vorderseite des ersten Wafers (SW) heruntergezogen wird und damit eine feste Verbindungsstruktur (BB, BB') bildet.

## Claims

1. Micromechanical cap structure, having:
- a first wafer (SW) having a micromechanical functional structure (OMMS),
- a second wafer (1) for forming a cap over the micromechanical functional structure (OMMS),
- the first and second wafers (SW, 1) having a joining structure (BB, BB'), which joins the two wafers (SW, 1) to one another, in a common edge region,
**characterized in that**
- the first and second wafers (SW, 1) in a common inner region, have a support structure (S, S') with a metal/semiconductor contact for electrically connecting at least parts of the first and second wafers (SW, 1),
- the metal/semiconductor contact being of resilient, closed configuration
- and the first wafer (SW) consisting of a semiconductor material at least in the region of the support structure (S, S').

2. Micromechanical cap structure according to Claim 1, **characterized in that** the second wafer (1) has an elastic stressing, such that the metal/semiconductor contact is closed.

3. Micromechanical cap structure according to Claim 2, **characterized in that** the edge region of the second wafer (1), in the capped state, is convex with respect to the inner region of the second wafer (1).

4. Micromechanical cap structure according to one of the preceding claims, **characterized in that** the support structure (S, S') has a central support region (5) on the second wafer (1) and a corresponding central countersupport region (S') on the first wafer (SW).

5. Micromechanical cap structure according to one of the preceding claims, **characterized in that** the joining structure (BB, BB') has a peripheral edge region (33') of the first wafer (SW) and a peripheral edge region (BB), anodically bonded to it, of the second wafer (1).

6. Micromechanical cap structure according to one of the preceding claims, **characterized in that** the second wafer (1) has an annular cavity (K1) running around the support region (S).

7. Micromechanical cap structure according to Claim 6, **characterized in that** the second wafer (1) has a metallic inlay structure (15') which at least partially lines the support region (S) and the cavity (K1) but leaves clear the edge region (BB), the metallic inlay structure (15') being electrically connected to the metal/semiconductor contact.

8. Micromechanical cap structure according to either of the preceding Claims 6 and 7, **characterized in that** the cavity (K1) is provided in the base material of the second wafer (1), and a glass layer (5) is provided on the cavity (K1), the edge region (BB) and the support region (S).

9. Process for producing a micromechanical cap structure according to at least one of the preceding claims, **characterized by** the steps of:
- placing the first and second wafer (1, SW) on top of one another, in such a manner that the parts of the support structure (S, S') form a common contact surface and the parts of the subsequent joining structure (BB, BB') are aligned opposite one another,
- applying an anodic bonding voltage (UBOND) between the first and second wafers (1, SW), so that the edge region (BB) of the front surface of the second wafer (1) is drawn down onto the edge region (BB') on the front surface of the first wafer (SW) so as to form a fixed joining structure (BB, BB').

## Revendications

1. Structure de capuchon micromécanique comprenant :
- une première plaquette (SW) avec une structure fonctionnelle micromécanique (OMMS),
- une deuxième plaquette (1) pour former un capuchon sur la structure fonctionnelle micromécanique (OMMS), et
- les première et deuxième plaquettes (SW, 1) présentant dans une zone périphérique commune une structure de liaison (BB, BB') qui relie les deux plaquettes (SW, 1) l'une à l'autre,
**caractérisée en ce que**
- les première et deuxième plaquettes (SW, 1) présentent dans une zone intérieure commune une structure d'appui (S, S') avec un contact semi-conducteur métallique pour connecter électriquement au moins des éléments des première et deuxième plaquettes (SW, 1 les uns aux autres),
- le contact semi-conducteur métallique présente une forme élastiquement fermée, et
- la première plaquette (SW), au moins dans la zone de la structure d'appui (S, S'), est réalisée en un matériau semi-conducteur.

2. Structure de capuchon micromécanique selon la revendication 1,
**caractérisée en ce que**
la deuxième plaquette (1) présente un serrage élastique pour fermer le contact semi-conducteur métallique.

3. Structure de capuchon micromécanique selon la revendication 2,
**caractérisée en ce qu'**
à l'état recouvert, la zone périphérique de la deuxième plaquette (1) est bombée par rapport à la zone intérieure de la deuxième plaquette (1).

4. Structure de capuchon micromécanique selon l'une quelconque des revendications précédentes,
**caractérisée en ce que**
la structure d'appui (S, S') présente une zone d'appui centrale (5) sur la deuxième plaquette (1) et une zone d'appui centrale antagoniste (S') correspondante sur la première plaquette (SW).

5. Structure de capuchon micromécanique selon l'une quelconque des revendications précédentes,
**caractérisée en ce que**
la structure de liaison (BB, BB') présente une zone périphérique circulaire (33') de la première plaquette (SW) et une zone périphérique circulaire (BB) de la deuxième plaquette (1) reliée anodiquement à celle-ci.

6. Structure de capuchon micromécanique selon l'une quelconque des revendications précédentes,
**caractérisée en ce que**
la deuxième plaquette (1) présente une cavité annulaire (K1) entourant la zone d'appui (S).

7. Structure de capuchon micromécanique selon la revendication 6,
**caractérisée en ce que**
la deuxième plaquette (1) présente une structure de revêtement intérieur métallique (15') qui recouvre la zone d'appui (S) et la cavité (K1) au moins partiellement, et qui laisse libre la zone périphérique (BB), la structure de revêtement intérieur métallique (15') étant en liaison électrique avec le contact semi-conducteur métallique.

8. Structure de capuchon micromécanique selon l'une quelconque des revendications 6 ou 7 précédentes,
**caractérisée par**
la cavité (K1) dans le matériau de base de la deuxième plaquette (1), et une couche en verre (5) sur la cavité (K1), la zone périphérique (BB) et la zone d'appui (S).

9. Procédé de fabrication d'une structure de capuchon micromécanique selon au moins l'une quelconque des revendications précédentes,
**caractérisé par**
les étapes suivantes :
- superposition des première et deuxième plaquettes (1, SW) de sorte que les éléments de la structure d'appui (S, S') forment une surface de contact commune et les éléments de la structure de liaison (BB, BB') ultérieure soient orientées les uns face aux autres,
- application d'une tension de contact anodique (UBOND) entre les première et deuxième plaquettes (1, SW) de sorte que la zone périphérique (BB) de la face avant de la deuxième plaquette (1) soit tirée sur la zone périphérique (BB') de la face avant de la première plaquette (SW) et forme ainsi une structure de liaison fixe (BB, BB').
